# EUROPÄISCHE PATENTSCHRIFT

(11) **EP 1 891 320 B1**
(45) Veröffentlichungstag und Bekanntmachung des Hinweises auf die Patenterteilung: **17.07.2013**
(21) Anmeldenummer: 06725513.3
(22) Anmeldetag: 03.04.2006
(51) Int. Cl.: F02M 51/06, F02M 61/08, H01L 41/053, F02M 61/16, F02M 63/00

(54) **BRENNSTOFFEINSPRITZVENTIL**
FUEL INJECTION VALVE
SOUPAPE D'INJECTION DE COMBUSTIBLE

(30) Priorität: 30.05.2005 DE 102005024710
(43) Veröffentlichungstag der Anmeldung: 27.02.2008
(73) Patentinhaber: Robert Bosch GmbH, 70442 Stuttgart (DE)
(72) Erfinder: SCHOOR, Ulrich, 70439 Stuttgart (DE); JUPE, Michael, 71636 Ludwigsburg (DE)
(86) Internationale Anmeldenummer: PCT/EP2006/061267
(87) Internationale Veröffentlichungsnummer: WO 2006/128749

(56) Entgegenhaltungen:
- EP-A- 1 079 158
- US-A- 4 553 059
- US-A1- 2003 150 939
- US-A1- 2004 164 175

## Beschreibung

### Stand der Technik

Die Erfindung betrifft ein Brennstoffeinspritzventil für Brennstoffeinspritzanlagen von Brennkraftmaschinen. Speziell betrifft die Erfindung einen Injektor für Brennstoffeinspritzanlagen von luftverdichtenden, selbstzündenden Brennkraftmaschinen.

In der Schrift US 2003/0150939 A1 ist ein Brennstoffeinspritzventil offenbart, das ein in einem Ventilgehäuse angeordneten Aktor aufweist an dem ein Übergangsstück vorgesehen ist. Der Aktor ist umfänglich von einer Rohrfeder umschlossen, die das Übergangsstück abschnittsweise umschließt und in einem Befestigungsbereich mit dem Übergangsstück verbunden ist.

Aus der DE 198 56 202 A1 ist ein Brennstoffeinspritzventil mit einem piezoelektrischen Aktor bekannt. Bei dem bekannten Brennstoffeinspritzventil ist der Aktor in einem Aktorraum angeordnet, wobei ein Aktorkopf und ein Aktorfuß an den Aktor angesetzt sind. Der in dem Aktorraum angeordnete Aktor ist mittels einer durch den Aktorraum strömenden Kühlluft kühlbar. Um den Aktor vor direkter Luftfeuchte zu schützen, ist der Aktorkörper einschließlich seiner Elektrodenzuleitungen durch einen Elastomermantel oder einen Schrumpfschlauch geschützt.

Das aus der DE 198 56 202 A1 bekannte Brennstoffeinspritzventil hat den Nachteil, dass der

Aktorraum gegen den Brennstoff abzudichten ist, wobei sich der Bauraum des Brennstoffeinspritzventils vergrößert, und dass an den Enden des Aktors Luftfeuchte durch den Spalt zwischen dem Aktor und dem Aktorkopf beziehungsweise dem Aktorfuß an die aktiven Schichten des Aktors dringen kann, wodurch die Funktionsfähigkeit des Aktors beeinträchtigt ist.

### Vorteile der Erfindung

Das erfindungsgemäße Brennstoffeinspritzventil mit den Merkmalen des Anspruchs 1 hat demgegenüber den Vorteil, dass der Aktor durch den Dehnschlauch, der sowohl den Aktor radial umschließt als auch das Übergangsstück zumindest abschnittsweise radial umschließt, der Aktor zuverlässig abgedichtet ist. Durch diese Abdichtung kann der Aktor auch in einen mit Kraftstoff durchflossenen Raum des Brennstoffeinspritzventils eingebracht werden, wobei der Dehnschlauch den Aktor gegen Schmutzpartikel im Brennstoff schützt. Ferner kann durch den Dehnschlauch eine elektrische Isolation zu dem Ventilgehäuse des Brennstoffeinspritzventils gewährleistet werden.

Durch die in den Unteransprüchen aufgeführten Maßnahmen sind vorteilhafte Weiterbildungen des im Anspruch 1 angegebenen Brennstoffeinspritzventils möglich.

Vorteilhaft ist, dass der Dehnschlauch in zumindest einem Bereich des Aktors in einer axialen Richtung dehnbar ist, um eine Ausdehnung des Aktors in der axialen Richtung zur Betätigung des Ventilschließkörpers zu ermöglichen. Der Dehnschlauch kann insgesamt dehnbar ausgestaltet sein. Es ist auch möglich, dass mehrere ringförmige Bereiche vorgesehen sind, in denen der Dehnschlauch dehnbar ist. Eine weitere mögliche Ausgestaltung besteht darin, dass die Dehnbarkeit des Dehnschlauches auf den Bereich des Aktors begrenzt ist. Die Dehnbarkeit des Dehnschlauches hat den Vorteil, dass der Dehnschlauch sowohl im Ruhezustand als auch bei der Betätigung des Aktors zumindest im wesentlichen an dem Aktor anliegt, wodurch eine Störung eines gegebenenfalls am Aktor vorbeifließenden Brennstoffs vermieden wird.

Vorteilhaft ist es, dass das Übergangsstück auf einer Seite, an der das Übergangsstück an den Aktor angefügt ist, an eine Querschnittsform des Aktors angepasst ist und dass das Übergangsstück in dem Befestigungsbereich, an dem der Dehnschlauch mit dem Übergangsstück verbunden ist, abgerundet ausgestaltet ist. Dadurch kann auch bei hohem Druck des Brennstoffes, der auf den Dehnschlauch einwirkt, eine Beschädigung des Dehnschlauches verhindert werden.

Ferner ist es vorteilhaft, dass das erfindungsgemäße Übergangsstück derart ausgestaltet ist, dass eine Querschnittsform des Übergangsstückes von der Seite, an der das Übergangsstück an den Aktor angefügt ist, gleichmäßig in eine Querschnittsform in dem Befestigungsbereich des Übergangsstückes übergeht.

Die Querschnittsform des Aktors weist mehrere Ecken auf und kann beispielsweise speziell quadratisch ausgebildet sein. Das Übergangsstück ist auf der Seite des Aktors an die Querschnittsform des Aktors angepasst, so dass die Querschnittsform des Übergangsstückes ebenfalls mehrere Ecken aufweist und speziell quadratisch ausgebildet ist. Durch den gleichmäßigen Übergang zu der Querschnittsform in dem Befestigungsbereich werden in axialer Richtung, in der die Dehnkräfte des Dehnschlauches auf die Befestigung wirken, scharfe Kanten und vorzugsweise auch enge Krümmungsradien vermieden, wodurch eine Beschädigung des Dehnschlauches im Betrieb des Brennstoffeinspritzventils verhindert ist.

In vorteilhafter Weise ist das erfindungsgemäße Übergangsstück im Befestigungsbereich zumindest abschnittsweise konisch ausgestaltet. Anch kann as zumindest abschnittsweise kegelstumpfförmig ausgestaltet sein. Ferner liegt der Dehnschlauch vorzugsweise umfänglich an dem Übergangsstück an, um eine formschlüssige Verbindung zwischen dem Dehnschlauch und dem Übergangsstück im Befestigungsbereich zu erzielen. Auf diese Weise ist eine vorteilhafte Befestigung des Dehnschlauches geschaffen, die speziell bei einer Betätigung des Aktors und/oder bei Beaufschlagung des Dehnschlauches mit dem Druck des Brennstoffes eine zuverlässige Abdichtung des Inneren des Dehnschlauches, das heißt des Aktors, gegenüber dem Außenbereich des Dehnschlauches, das heißt dem Brennstoff, gewährleistet.

Ferner ist es vorteilhaft, dass der Dehnschlauch in dem Befestigungsbereich mittels eines Befestigungsringes, der den Dehnschlauch und das Übergangsstück zumindest teilweise umschließt, an dem Übergangsstück befestigt ist. Dadurch kann der Dehnschlauch an dem Übergangsstück fixiert werden. Außerdem bewirkt der Befestigungsring insbesondere im drucklosen Zustand des Brennstoffeinspritzventils eine zusätzliche Abdichtung des Inneren des Dehnschlauches gegenüber den Umgebungsmedien.

Vorteilhaft ist es außerdem, dass an beiden Enden des Aktors jeweils ein Übergangsstück vorgesehen ist, wobei eines als Aktorkopf und das andere als Aktorfuß ausgebildet ist. Der Aktor kann dadurch zusammen mit den Übergangsstücken und dem Dehnschlauch als modulare Baugruppe ausgestaltet werden, wodurch sich die Montage des Brennstoffeinspritzventils vereinfacht. Außerdem kann dadurch eine zuverlässige Abdichtung des Aktors an beiden Enden erzielt werden.

### Zeichnung

Bevorzugte Ausführungsbeispiele der Erfindung sind in der nachfolgenden Beschreibung anhand der beigefügten Zeichnungen näher erläutert. Es zeigt:
Fig. 1 ein erstes Ausführungsbeispiel des Brennstoffeinspritzventils der Erfindung in einer axialen Schnittdarstellung;
Fig. 2 ein Übergangsstück eines Brennstoffeinspritzventils gemäß einem zweiten Ausführungsbeispiel der Erfindung;
Fig. 3 eine Befestigungshülse zur Befestigung eines Dehnschlauches entsprechend einem dritten Ausführungsbeispiel der Erfindung und
Fig. 4 ein Übergangsstück eines Brennstoffeinspritzventils gemäß einem vierten Ausführungsbeispiel der Erfindung in einer auszugsweisen Darstellung.

### Beschreibung der Ausführungsbeispiele

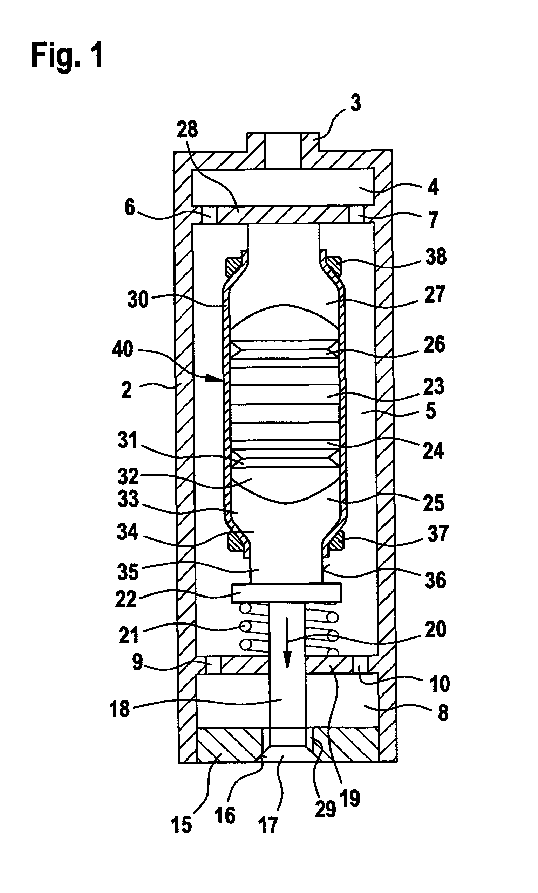

Fig. 1 zeigt ein erstes Ausführungsbeispiel eines Brennstoffeinspritzventils 1 der Erfindung. Das Brennstoffeinspritzventil 1 kann insbesondere als Injektor für Brennstoffeinspritzanlagen von luftverdichtenden, selbstzündenden Brennkraftmaschinen dienen. Insbesondere eignet sich das Brennstoffeinspritzventil 1 für Nutzkraftwagen oder Personenkraftwagen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Das erfindungsgemäße Brennstoffeinspritzventil 1 eignet sich jedoch auch für andere Anwendungsfälle.

Das Brennstoffeinspritventil 1 weist ein aus mehreren Teilen bestehenden Ventilgehäuse 2 und einen mit dem Ventilgehäuse 2 verbundenen Brennstoffeinlassstutzen 3 auf. An den Brennstoffeinlassstutzen 3 ist eine (nicht dargestellte) Brennstoffleitung anschließbar, um Brennstoff in einen Innenraum 4 des Ventilgehäuses 2 einzuführen. Ferner ist im Inneren des Ventilgehäuses 2 ein Aktorraum 5 ausgebildet, der durch eine Hochdruckbohrung des Ventilgehäuses 2 ausgebildet sein kann. Der Aktorraum 5 steht über Durchlassöffnungen 6, 7 mit dem Innenraum 4 in Verbindung. Außerdem ist im Inneren des Ventilgehäuses 2 ein Brennstoffraum 8 vorgesehen, der über Durchlassöffnungen 9, 10 mit dem Aktorraum 5 verbunden ist. Der Innenraum 4, die Durchlassöffnungen 6, 7, der Aktorraum 5, und die Durchlassöffnungen 9, 10 bilden eine Brennstoffleitung von dem Brennstoffeinlassstutzen 3 in den Brennstoffraum 8, um über den Brennstoffeinlassstutzen 3 in das Brennstoffeinspritzventil 1 eingeführten Brennstoff in den Brennstoffraum 8 zu leiten. Im Betrieb des Brennstoffeinspritzventils 1 befindet sich daher auch im Aktorraum 5 Brennstoff unter hohem Druck.

Das Ventilgehäuse 2 ist mit einem Ventilsitzkörper 15 verbunden, an dem eine Ventilsitzfläche 16 ausgebildet ist. Die Ventilsitzfläche 16 wirkt mit einem Ventilschließkörper 17 zu einem Dichtsitz zusammen, wobei in dem dargestellten Ausgangszustand der Dichtsitz geschlossen ist. Dabei ist der Ventilschließkörper 17 einstückig mit einer Ventilnadel 18 ausgebildet, die von einer durch ein Gehäuseteil 19 ausgebildete Ventilnadelführung in einer axialen Richtung 20 geführt ist. Das Gehäuseteil 19 weist dabei die Durchlassöffnungen 9, 10 auf. Eine Ventilfeder 21 stützt sich einerseits an dem Gehäuseteil 19 und andererseits an einer Druckplatte 22 ab, die mit der Ventilnadel 18 verbunden ist, so dass der durch den Ventilschließkörper 17 und die Ventilsitzfläche 16 gebildete Dichtsitz auf Grund der Kraft der Ventilfeder 21 mit einer Schließkraft beaufschlagt ist.

In dem Aktorraum 5 ist ein aus mehreren aktiven Schichten bestehender piezoelektrischer Aktor 23 vorgesehen. An einem ersten Ende 24 liegt der Aktor 23 an einem Übergangsstück 25 an, das an den Aktor 23 angefügt ist. An einem zweiten Ende 26 des Aktors 23 liegt der Aktor 23 an einem Übergangsstück 27 an, das an den Aktor 23 angefügt ist. Das Übergangsstück 27 ist in dem dargestellten Ausführungsbeispiel als Aktorfuß ausgestaltet und das Übergangsstück 25 ist als Aktorkopf ausgestaltet. Zur Betätigung des Brennstoffeinspritzventils 1 wird der Aktor 23 mit einer Betätigungsspannung beaufschlagt, wodurch der Aktor 23 sich in axialer Richtung 20 ausdehnt. Da der Aktor 23 über das Übergangsstück 27 an einem Gehäuseteil 28, in dem die Durchlassöffnungen 6, 7 ausgebildet sind, abgestützt ist, bedingt die Betätigung des Aktors 23 eine Verschiebung des Übergangsstückes 25 in der axialen Richtung 20 entgegen der Kraft der Ventilfeder 21, so dass sich der Ventilschließkörper 17 von der Ventilsitzfläche 16 abhebt und der zwischen der Ventilsitzfläche 16 und dem Ventilschließkörper 17 gebildete Dichtsitz geöffnet wird. Dadurch kommt es zum Abspritzen von Brennstoff aus dem Brennstoffraum 8 über den ringförmigen Spalt 29 und den geöffneten Dichtsitz in einen (nicht dargestellten) Brennraum einer Brennkraftmaschine.

Nach der Betätigung des Brennstoffeinspritzventils 1 zieht sich der Aktor 23 wieder zusammen, so dass auf Grund der Kraft der Ventilfeder 21 eine Rückstellung der Ventilnadel 18 entgegen der axialen Richtung 20 in die in der Fig. 1 dargestellte Ausgangslage erfolgt, wodurch der zwischen der Ventilsitzfläche 16 und dem Ventilschließkörper 17 gebildete Dichtsitz wieder geschlossen ist.

Das Brennstoffeinspritzventil 1 weist einen Dehnschlauch 30 auf, der den Aktor 23 umfänglich umschließt. Ferner umschließt der Dehnschlauch 30 einen Teil des Übergangsstückes 27 umfänglich. Andererseits umschließt der Dehnschlauch 30 auch einen Teil des Übergangsstückes 25 umfänglich. Das Übergangsstück 25 weist einen Bereich 31 auf, an dem es an die quadratische Form des Querschnittes des ersten Endes 24 des Aktors 23 angepasst ist, so dass der Bereich 31 des Übergangsstückes 25 ebenfalls quadratisch ausgestaltet ist. Durch die angepasste Ausgestaltung wird erreicht, dass der Dehnschlauch 30 von dem Aktor 23 auf das Übergangsstück 25 knickfrei übergeht. Außerdem weist das Übergangsstück 25 einen Übergangsbereich 32 auf, in dem die Querschnittsform des Übergangsstückes 25 von der quadratischen Form im Bereich 31 zu einer kreisförmigen Querschnittsform in einem Bereich 33 gleichmäßig übergeht. An den Bereich 33 schließt sich ein Bereich 34 an, in dem das Übergangsstück 25 konisch ausgebildet ist, das heißt, dass sich der Querschnitt des Übergangsstückes 25 im Bereich 34 in axialer Richtung 20 verringert. An den konischen Bereich 34 schließt sich ein Bereich 35 an, in dem das Übergangsstück 25 zylinderförmig ausgestaltet ist. In dem dargestellten Ausführungsbeispiel umschließt der Dehnschlauch 30 die Bereiche 31, 32, 33 umfänglich. Außerdem wird auch noch ein Teil des Bereiches 35 des Übergangsstückes 25 von dem Dehnschlauch 30 umfänglich umschlossen. Alternativ ist es auch möglich, dass der Dehnschlauch 30 nur einen Teil des Bereiches 34 des Übergangsstückes umfänglich umschließt, so dass der Bereich 35 des Übergangsstückes 25 frei bleibt.

In dem Bereich 34, in dem das erfindungsgemäße Übergangsstück konisch ausgebildet ist, liegt der Dehnschlauch 30 an einer Außenseite 36 des Übergangsstückes 25 an, wodurch eine formschlüssige Verbindung zwischen dem Dehnschlauch und dem Übergangsstück 25 ausgebildet ist, die eine Verschiebung des Dehnschlauches 30 entgegen der axialen Richtung 20 verhindert. Zur Fixierung des Dehnschlauches 30 ist ein aus Kunststoff oder Metall ausgebildeter Befestigungsring 37 vorgesehen, der den Dehnschlauch 30 radial gegen den Bereich 34 des Übergangsstückes 25 mit einer Befestigungskraft beaufschlagt. Durch die beschriebene Ausgestaltung der Verbindung zwischen dem Dehnschlauch 30 und dem Übergangsstück 25 wird das Innere des Dehnschlauches 30, in dem der Aktor 23 angeordnet ist, gegen im Aktorraum 5 vorgesehenen Brennstoff, insbesondere gegen Schmutzpartikel im Brennstoff, abgedichtet und geschützt. Um auch seitens des Übergangsstückes 27 einen derartigen Schutz beziehungsweise eine solche Abdichtung zu erreichen, ist außerdem eine Verbindung zwischen dem Übergangsstück 27 und dem Dehnschlauch 30 ausgebildet, wobei außerdem ein Befestigungsring 38 vorgesehen ist. Diese Ausgestaltung entspricht der Verbindung zwischen dem Dehnschlauch 30 und dem Übergangsstück 25, wobei durch die formschlüssige Verbindung zwischen dem Dehnschlauch 30 und dem Übergangsstück 27 eine Verschiebung des Dehnschlauches in der axialen Richtung 20 verhindert ist.

Der Dehnschlauch 30 ist zumindest in einem Bereich 40 des Aktors 23 dehnbar, um bei einer Betätigung des Aktors 23 eine Dehnung des Dehnschlauches 30 in der axialen Richtung 20 zu ermöglichen. Der Bereich 40 erstreckt sich vorzugsweise entlang des gesamten Aktors 23 und gegebenenfalls auch entlang der Übergangsstücke 25, 27.

Durch die Verbindung des Dehnschlauches 30 mit den Übergangsstücken 25, 27 ist jedenfalls ein Schutz des Aktors gegen Schmutzpartikel und dergleichen im Brennstoff gewährleistet. Um den Aktor 23 zusätzlich gegen einen gegebenenfalls eintretenden Brennstoff weiter zu schützen, kann der Aktor 23 außerdem mit einer Schutz- und Isolationsschicht versehen werden, die beispielsweise aus einem Lack, einer Folie oder aus Parylene ausgebildet sein kann. Dadurch wird der Schutz des Aktors 23 gegenüber Einflüssen aus dem Aktorraum 5 weiter verbessert.

Die beschriebene Ausgestaltung hat außerdem den Vorteil einer einfachen Montage. Dabei können die Übergangsstücke 25, 27 an den Aktor 23 angefügt werden. Anschließend kann der Dehnschlauch 30 über den Aktorverbund gezogen und dann formschlüssig über den Verbund angelegt werden. Zur Fixierung des Dehnschlauches 30 können dann die Befestigungsringe 37, 38 dienen. Somit sind bei der Montage lediglich Fügeprozesse erforderlich, wodurch auf Schweiß- und Schraubverbindungen verzichtet werden kann. Außerdem ergibt sich ein besonders kompakter Aufbau, insbesondere ein optimierter Durchmesser, so dass die Baugröße des Brennstoffeinspritzventils 1 verringert ist. Durch das Anliegen des Dehnschlauches 30 am Aktor 23 ist außerdem eine vorteilhafte Ableitung der entstehenden Wärme an den durch den Aktorraum 5 fließenden Brennstoff möglich. Somit kann gegebenenfalls eine zusätzliche Vergussmasse zur Wärmeabfuhr eingespart werden.

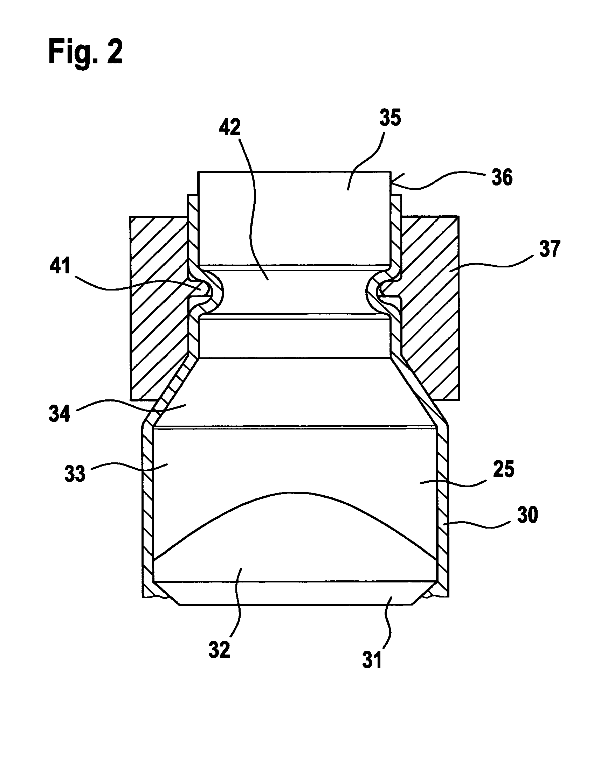

Fig. 2 zeigt ein als Aktorkopf ausgebildetes Übergangsstück 25 eines Brennstoffeinspritzventils gemäß einem zweiten Ausführungsbeispiel. Sich entsprechende Elemente sind in allen Figuren mit übereinstimmenden Bezugszeichen versehen, wodurch sich eine wiederholende Beschreibung erübrigt. Die Ausgestaltung des als Aktorfuß ausgebildeten Übergangsstückes 27 ergibt sich entsprechend zu der des Übergangsstückes 25.

Bei dem in Fig. 2 gezeigten Übergangsstück 25 schließt sich an den zylinderförmigen Bereich 35 ein konischer Bereich 34 an, wobei der zylinderförmige Bereich 35 des Übergangsstückes eine radial umlaufende Nut 42 aufweist. Die Nut 42 weist dabei in radialer Richtung vorzugsweise einen zumindest näherungsweise kreisförmigen oder elliptischen Querschnitt auf. Allerdings kann die Nut 42 in radialer Richtung auch einen rechteckigen oder einen anders ausgebildeten Querschnitt aufweisen. Dabei sind die Übergangsstellen vorzugsweise abgerundet ausgestaltet.

In die Nut 42 ist der Dehnschlauch 30 eingebracht, wobei sich der Dehnschlauch zumindest teilweise der Geometrie der Nut 42 anpasst. Außerdem weist der Befestigungsring 37 im Bereich der Nut 42 einen radial umlaufenden, wulstförmig ausgebildeten Vorsprung 41 auf, um den Dehnschlauch 30 in der Nut 42 zu halten.

In diesem Ausführungsbeispiel ist die Nut 42 als abgerundete Rille 42 in dem Übergangsstück 35 ausgebildet, in die der den Dehnschlauch 30 leicht spannende, mit der angepassten Gegenform ausgestaltete Befestigungsring 37 zur Montage über den zylinderförmigen Bereich 42 des Übergangsstückes geschoben wird und in die in Fig. 2 dargestellte Endposition einrastet. Die Anpassung der Geometrie des Befestigungsringes 37 erfolgt dabei an den zylinderförmigen Bereich 35, den konischen Bereich 34 und die im zylinderförmigen Bereich 35 vorgesehene Nut 42 des Übergangsstückes, wobei die Wandstärke des Dehnschlauches 30 berücksichtigt ist. Durch den erzeugten Formschluss bleiben sowohl der Dehnschlauch 30 als auch der Befestigungsring 37 in ihrer Lage fixiert.

Der Dehnschlauch kann dabei auch unter leichter Zugspannung mittels des Befestigungsringes in der Nut 42 eingeklemmt werden, so dass die innerhalb des Dehnschlauches angeordneten Teile des Brennstoffeinspritzventils gegeneinander positioniert sind und ein Verkleben dieser Teile mittels eines Klebstoffes nicht erforderlich ist. Sofern der Dehnschlauch 30 als Schrumpfschlauch 30 ausgebildet ist, kann nach dem Anbringen zunächst ein Schrumpfen des Dehnschlauches 30 an den Übergangsstücken 25, 27 erfolgen. Durch ein anschließendes Schrumpfen des Dehnschlauches 30 auch in dem zwischen den Übergangsstücken 25, 27 liegenden Bereich wird dann eine Kraft zum Zusammenhalten der innerhalb des Dehnschlauches angeordneten Teile des Brennstoffeinspritzventils 1 beziehungsweise eine auf den Dehnschlauch im Bereich der Nut 42 wirkende Zugspannung erzeugt.

Der Befestigungsring 37 kann aus einem oder mehreren Materialien bestehen. Speziell können ein Polymer, insbesondere ein gegebenenfalls glasfaserverstärktes Polyamid, und/oder ein Metall zum Einsatz kommen, die den Umgebungsflüssigkeiten, insbesondere dem Brennstoff, standhalten.

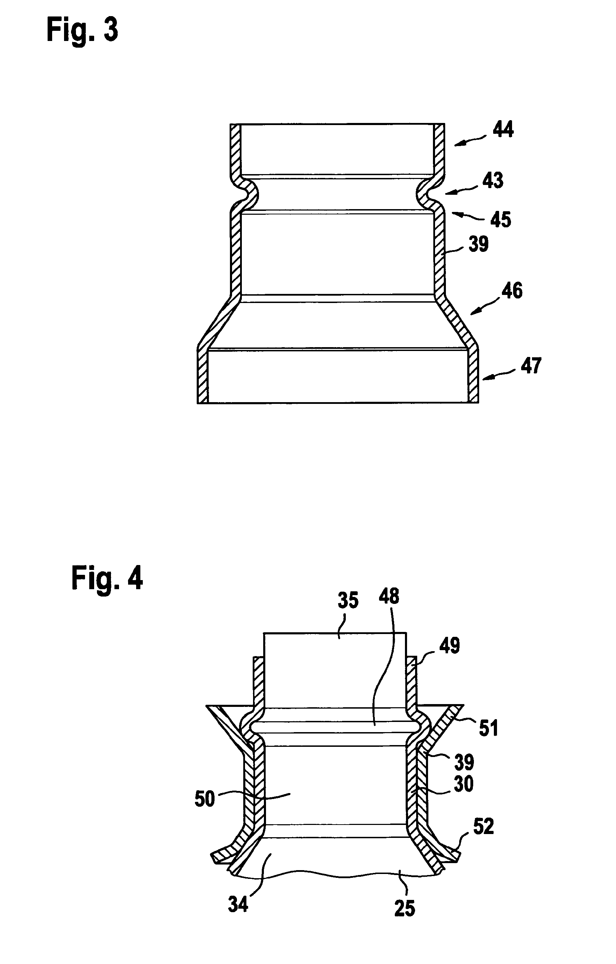

Fig. 3 zeigt eine Befestigungshülse 39 eines Brennstoffeinspritzventils 1 gemäß einem dritten Ausführungsbeispiel in einer axialen Schnittdarstellung. Die Befestigungshülse 39 kann bei dem Brennstoffeinspritzventil 1 gemäß dem in Fig. 2 dargestellen Ausführungsbeispiel anstelle des Befestigungsringes 37 zum Einsatz kommen.

Die Befestigungshülse 39 weist eine Sicke 43 auf, die den Dehnschlauch 30 in die Nut 42 drückt, um eine zuverlässige Verbindung des Dehnschlauches 30 mit dem Übergangstück 25 zu erzielen. Außerdem weist die Befestigungshülse 39 an die Sicke 43 angrenzende Bereiche 44, 45 auf, die an den zylinderförmigen Bereich 35 angepasst sind, um den Dehnschlauch 30 zwischen der Befestigungshülse 39 und dem Übergangsstück 25 zu führen. Außerdem ist die Befestigungshülse 39 in einem Bereich 46 konisch ausgebildet, um den Dehnschlauch 30 zwischen der Befestigungshülse 39 und dem konischen Bereich 34 des Übergangsstückes 25 einzuklemmen. An den Bereich 46 schließt sich ein Bereich 47 der Befestigungshülse 39 an, in dem die Befestigungshülse 39 einen an den Bereich 33 des Übergangsstückes 25 angepassten, vorzugsweise konstanten, Durchmesser aufweist. Im Bereich 47 wird der Dehnschlauch 30 durch die Befestigungshülse 39 geschützt. Außerdem kann dabei ein Anliegen des Dehnschlauches 30 an dem Übergangsstück 25 gewährleistet werden.

Die Befestigungshülse 39 kann aus einem Metallblech ausgebildet sein. Die Sicke 43 bildet eine Verengung 43, die durch eine Einprägung ausgebildet werden kann. Dabei können Verengungen 43 in Umfangsrichtung auch nur abschnittsweise ausgebildet sein.

Fig. 4 zeigt ein Übergangsstück 25 eines Brennstoffeinspritzventils 1 gemäß einem vierten Ausführungsbeispiel der Erfindung in einer auszugsweisen Schnittdarstellung.

In diesem Ausführungsbeispiel weist das Übergangsstück 25 einen radial umlaufenden Wulst 48 auf, durch den ein Vorsprung 48 ausgebildet ist. Der Wulst 48 ist dabei anstelle der in Fig. 2 dargestellten Nut 42 an dem Übergangsstück 25 vorgesehen.

Allerdings können anstelle des Wulstes 48 oder der Nut 42 auch mehrere Wülste beziehungsweise Nuten vorgesehen sein. Es kann auch eine Kombination von einem oder mehreren Wülsten 48 mit einer oder mehreren Nuten 42 an einem Übergangsstück 25 vorgesehen sein.

Der Dehnschlauch 30 ist an seinem Ende 49 zumindest etwas über den Wulst 48 hinaus gezogen bzw. geführt, um auch nach einem eventuellen Verrutschen des Dehnschlauches 30 eine Befestigung in axialer Richtung zu gewährleisten. Außerdem ist eine Befestigungshülse 39 vorgesehen, die das Übergangsstück 25 zumindest in dem Bereich 50 zwischen dem Wulst 48 und dem konischen Bereich 34 umschließt. Ferner weist die Befestigungshülse 39 aufgetriebene Enden 51, 52 auf, wobei das Ende 51 axial zumindest etwas über den Wulst 48 ragt und das Ende 52 axial zumindest etwas in den konischen Bereich 34 hinein ragt. Dadurch wird eine elastische Vorspannung der Befestigungshülse 39 erzielt, die den Dehnschlauch 30 einerseits zwischen dem Wulst 48 und der Befestigungshülse 39 und andererseits zwischen dem konischen Bereich 34 des Übergangsstückes 25 und der Befestigungshülse 39 einklemmt. Dadurch ist eine zuverlässige Befestigung des Dehnschlauches 30 an dem Übergangsstück 25 gewährleistet.

Das Ende 51 der Befestigungshülse 39 bildet eine Aufweitung 51 aus, die an den Wulst 48 angepasst ist. Die Aufweitung 51 stellt dabei eine Ausführungsform dar, die umgekehrt zu der in Fig. 3 dargestellten Ausführung mit einer durch die Sicke 43 gebildeten Einziehung 43 ausgestaltet ist. Anstelle eines aufgetriebenen Endes 51 kann daher auch eine Aufweitung 51 vorgesehen sein, bei der die Befestigungshülse 39 auf beiden Seiten des Wulstes 48 an dem Dehnschlauch 30 anliegt und den Bereich 35 des Übergangsstückes umschließt. Die Enden 51, 52 der Befestigungshülse 42 können auch durch Walzen ausgebildet sein.

Die Erfindung ist nicht auf die beschriebenen Ausführungsbeispiele beschränkt.

## Patentansprüche

1. Brennstoffeinspritzventil (1), insbesondere Injektor für Brennstoffeinspritzanlagen von luftverdichtenden, selbstzündenden Brennkraftmaschinen, mit einem in einem Ventilgehäuse (2) angeordneten Aktor (23) und einem von dem Aktor (23) mittels einer Ventilnadel (18) betätigbaren Ventilschließkörper (17), der mit einer Ventilsitzfläche (16) zu einem Dichtsitz zusammenwirkt, wobei zumindest ein Übergangsstück (25, 27) vorgesehen ist,
das an den Aktor (23) angefügt ist, dass zumindest ein Dehnschlauch (30) vorgesehen ist, der den Aktor (23) umfänglich umschließt und der das Übergangsstück (25, 27) zumindest abschnittsweise umfänglich umschließt, und dass der Dehnschlauch (30) in einem Befestigungsbereich (34) des Übergangsstückes (25, 27) zumindest mittelbar mit dem Übergangsstück (25, 27) verbunden ist,
**dadurch gekennzeichnet, dass** das Übergangsstück (25, 27) auf einer Seite (31),
an der das Übergangsstück (25, 27) an den Aktor (23) angefügt ist, an eine mehrere Ecken aufweisende Querschnittsform des Aktors (23) angepasst ist, und dass das Übergangsstück (25, 27) in dem Befestigungsbereich (34), an dem der Dehnschlauch (30) mit dem Übergangsstück (25, 27) verbunden ist, abgerundet ausgestaltet ist, wobei das Übergangsstück (25, 27) derart ausgestaltet ist, dass eine Querschnittsform des Übergangsstückes (25, 27) von der Seite (31), an der das Übergangsstück an den Aktor (23) angefügt ist, gleichmäßig in eine Querschnittsform in dem Befestigungsbereich (34) des Übergangsstückes (25, 27) übergeht, wobei das Übergangsstück (25, 27) im Befestigungsbereich (34) zumindest abschnittsweise konisch ausgestaltet ist und sich der Querschnitt in axialer Richtung verringert.

2. Brennstoffeinspritzventil nach Anspruch 1,
**dadurch gekennzeichnet,**
**dass** das Übergangsstück (25, 27) in dem Befestigungsbereich (34) zumindest abschnittsweise zumindest näherungsweise kegelstumpfförmig ausgestaltet ist.

3. Brennstoffeinspritzventil nach Anspruch 2, **dadurch gekennzeichnet,**
**dass** der Dehnschlauch (30) im Befestigungsbereich (34) umfänglich an dem Übergangsstück (25, 27) anliegt.

4. Brennstoffeinspritzventil nach Ansprüche 3,
**dadurch gekennzeichnet,**
**dass** der Dehnschlauch (30) in dem Befestigungsbereich (34) formschlüssig mit dem Übergangsstück (25, 27) verbunden ist.

5. Brennstoffeinspritzventil nach einem der Ansprüche 1 bis 4,
**dadurch gekennzeichnet,**
**dass** der Dehnschlauch (30) in dem Befestigungsbereich (34) mittels eines Befestigungselementes (37, 38; 39), der den Dehnschlauch (30) und das Übergangsstück (25, 27) zumindest teilweise umschließt, an dem Übergangsstück (25, 27) befestigt ist.

6. Brennstoffeinspritzventil nach Anspruch 5,
**dadurch gekennzeichnet,**
**dass** das Übergangsstück (25, 27) eine radial umlaufende Nut (42) aufweist, dass das Befestigungselement (37; 39) einen Vorsprung (41) aufweist und dass der Dehnschlauch (30) mittels des Vorsprungs (41) des Befestigungselementes (37; 42) in der Nut (42) des Übergangsstückes (25, 27) gehalten ist.

7. Brennstoffeinspritzventil nach Anspruch 6,
**dadurch gekennzeichnet,**
**dass** die Nut (42) in einem zylinderförmigen Bereich (35) des Übergangsstückes (25, 27) vorgesehen ist.

8. Brennstoffeinspritzventil nach Anspruch 5,
**dadurch gekennzeichnet,**
**dass** das Übergangsstück (25, 27) einen radial umlaufenden Wulst (48) aufweist, dass das Befestigungselement (39) eine Aufweitung (51) aufweist und dass der Dehnschlauch (30) zumindest im Bereich der Aufweitung (51) zwischen dem Befestigungselement (39) und dem Wulst (48) des Übergangsstückes (25, 27) eingeklemmt ist.

9. Brennstoffeinspritzventil nach Anspruch 8,
**dadurch gekennzeichnet,**
**dass** der Wulst (48) in einem zylinderförmigen Bereich (35) des Übergangsstückes (25, 27) vorgesehen ist.

10. Brennstoffeinspritzventil nach einem der Ansprüche 1 bis 9,
**dadurch gekennzeichnet,**
**dass** das Übergangsstück (25, 27) als Aktorkopf (25) oder als Aktorfuß (27) ausgebildet ist.

11. Brennstoffeinspritzventil nach einem der Ansprüche 1 bis 10, **dadurch gekennzeichnet,**
**dass** das Übergangsstück (25) an einem Ende (24) des Aktors (23) angefügt ist, und dass ein weiteres Übergangsstück (27) vorgesehen ist, das an einem anderen Ende (26) des Aktors (23) angefügt ist.

12. Brennstoffeinspritzventil nach einen der Ansprüche 1, 3, 4, 5, 6 oder 8 **dadurch gekennzeichnet, dass** der Dehnschlauch (30) in zumindest einem Bereich (40) des Aktors (23) in einer axialen Richtung (20) dehnbar ist, um eine Ausdehnung des Aktors (23) in der axialen Richtung (20) zur Betätigung des Ventilschließkörpers (17) zu ermöglichen.

## Claims

1. Fuel injection valve (1), in particular injector for fuel injection systems of air-compressing, autoignition internal combustion engines, having an actuator (23) arranged in a valve housing (2) and having a valve closing body (17) which can be actuated by the actuator (23) via a valve needle (18) and which interacts with a valve seat surface (16) to form a sealing seat, wherein at least one transition piece (25, 27) is provided which is joined to the actuator (23), wherein at least one expansion hose (30) is provided which circumferentially surrounds the actuator (23) and which circumferentially surrounds the transition piece (25, 27) at least in sections, and wherein the expansion hose (30) is connected at least indirectly to the transition piece (25, 27) in a fastening region (34) of the transition piece (25, 27), **characterized in that** the transition piece (25, 27), on a side (31) on which the transition piece (25, 27) is joined to the actuator (23), is matched to a cross-sectional shape of the actuator (23) with multiple corners, and **in that** the transition piece (25, 27) is of rounded design in the fastening region (34) at which the expansion hose (30) is connected to the transition piece (25, 27), wherein the transition piece (25, 27) is designed such that a cross-sectional shape of the transition piece (25, 27) merges uniformly from the side (31) at which the transition piece is joined to the actuator (23) into a cross-sectional shape in the fastening region (34) of the transition piece (25, 27), wherein the transition piece (25, 27) is of conical design at least in sections in the fastening region (34) and the cross section decreases in an axial direction.

2. Fuel injection valve according to Claim 1, **characterized**
**in that** the transition piece (25, 27) is of at least approximately frustoconical design at least in sections in the fastening region (34).

3. Fuel injection valve according to Claim 2, **characterized**
**in that** the expansion hose (30) bears circumferentially against the transition piece (25, 27) in the fastening region (34).

4. Fuel injection valve according to Claim 3, **characterized**
**in that** the expansion hose (30) is connected in a positively locking manner to the transition piece (25, 27) in the fastening region (34).

5. Fuel injection valve according to one of Claims 1 to 4,
**characterized**
**in that** the expansion hose (30) is fastened to the transition piece (25, 27) in the fastening region (34) by means of a fastening element (37, 38; 39) which at least partially surrounds the expansion hose (30) and the transition piece (25, 27).

6. Fuel injection valve according to Claim 5, **characterized**
**in that** the transition piece (25, 27) has a radially encircling groove (42), in that the fastening element (37; 39) has a projection (41), and in that the expansion hose (30) is held in the groove (42) of the transition piece (25, 27) by means of the projection (41) of the fastening element (37; 39).

7. Fuel injection valve according to Claim 6, **characterized**
**in that** the groove (42) is provided in a cylindrical region (35) of the transition piece (25, 27).

8. Fuel injection valve according to Claim 5, **characterized**
**in that** the transition piece (25, 27) has a radially encircling bead (48), in that the fastening element (39) has a widening (51), and in that the expansion hose (30) is clamped, at least in the region of the widening (51), between the fastening element (39) and the bead (48) of the transition piece (25, 27).

9. Fuel injection valve according to Claim 8, **characterized**
**in that** the bead (48) is provided in a cylindrical region (35) of the transition piece (25, 27).

10. Fuel injection valve according to one of Claims 1 to 9,
**characterized**
**in that** the transition piece (25, 27) is formed as an actuator head (25) or as an actuator foot (27).

11. Fuel injection valve according to one of Claims 1 to 10,
**characterized**
**in that** the transition piece (25) is joined to one end (24) of the actuator (23), and in that a further transition piece (27) is provided which is joined to another end (26) of the actuator (23).

12. Fuel injection valve according to one of Claims 1, 3, 4, 5, 6 or 8,
**characterized**
**in that** the expansion hose (30) is, at least in a region (40) of the actuator (23), expandable in an axial direction (20) in order to permit an expansion of the actuator (23) in the axial direction (20) for the actuation of the valve closing body (17).

## Revendications

1. Soupape d'injection de carburant (1), en particulier injecteur pour des installations d'injection de carburant de moteurs à combustion interne à auto-allumage et compression d'air, comprenant un actionneur (23) disposé dans un boîtier de soupape (2) et un corps de fermeture de soupape (17) pouvant être actionné par l'actionneur (23) au moyen d'une aiguille de soupape (18), lequel corps de fermeture de soupape coopère avec une surface de siège de soupape (16) pour produire un siège d'étanchéité, au moins une pièce de transition (25, 27) étant prévue, laquelle est assemblée à l'actionneur (23), au moins un tuyau d'extension (30) étant prévu, lequel entoure l'actionneur (23) sur sa périphérie et entoure au moins en partie sur sa périphérie la pièce de transition (25, 27), et le tuyau d'extension (30) étant connecté au moins de manière indirecte à la pièce de transition (25, 27) dans une région de fixation (34) de la pièce de transition (25, 27),
**caractérisée en ce que** la pièce de transition (25, 27) est adaptée à une forme en section transversale de l'actionneur (23) présentant plusieurs coins, d'un côté (31) au niveau duquel la pièce de transition (25, 27) est assemblée à l'actionneur (23), et **en ce que** la pièce de transition (25, 27), dans la région de fixation (34) au niveau de laquelle le tuyau d'extension (30) est connecté à la pièce de transition (25, 27), est configurée de manière arrondie, la pièce de transition (25, 27) étant configurée de telle sorte qu'une forme en section transversale de la pièce de transition (25, 27) se prolonge depuis le côté (31) au niveau duquel la pièce de transition est assemblée à l'actionneur (23), de manière uniforme en une forme en section transversale dans la région de fixation (34) de la pièce de transition (25, 27), la pièce de transition (25, 27) étant configurée sous forme au moins partiellement conique dans la région de fixation (34) et la section transversale se rétrécissant dans la direction axiale.

2. Soupape d'injection de carburant selon la revendication 1,
**caractérisée en ce que**
la pièce de transition (25, 27) est configurée au moins en partie au moins approximativement sous forme tronconique dans la région de fixation (34).

3. Soupape d'injection de carburant selon la revendication 2,
**caractérisée en ce que**
le tuyau d'extension (30) s'applique dans la région de fixation (34) sur la périphérie contre la pièce de transition (25, 27).

4. Soupape d'injection de carburant selon la revendication 3,
**caractérisée en ce que**
le tuyau d'extension (30) est connecté dans la région de fixation (34) par engagement par coopération de forme à la pièce de transition (25, 27).

5. Soupape d'injection de carburant selon l'une quelconque des revendications 1 à 4,
**caractérisée en ce que** le tuyau d'extension (30) est fixé à la pièce de transition (25, 27) dans la région de fixation (34) au moyen d'un élément de fixation (37, 38 ; 39) qui entoure le tuyau d'extension (30) et la pièce de transition (25, 27) au moins en partie.

6. Soupape d'injection de carburant selon la revendication 5,
**caractérisée en ce que**
la pièce de transition (25, 27) présente une rainure radialement périphérique (42), **en ce que** l'élément de fixation (37 ; 39) présente une saillie (41) et **en ce que** le tuyau d'extension (30) est maintenu au moyen de la saillie (41) de l'élément de fixation (37 ; 39) dans la rainure (42) de la pièce de transition (25, 27).

7. Soupape d'injection de carburant selon la revendication 6,
**caractérisée en ce que**
la rainure (42) est prévue dans une région de forme cylindrique (35) de la pièce de transition (25, 27).

8. Soupape d'injection de carburant selon la revendication 5,
**caractérisée en ce que**
la pièce de transition (25, 27) présente un bourrelet (48) radialement périphérique, **en ce que** l'élément de fixation (39) présente un élargissement (51) et **en ce que** le tuyau d'extension (30) est serré au moins dans la région de l'élargissement (51) entre l'élément de fixation (39) et le bourrelet (48) de la pièce de transition (25, 27).

9. Soupape d'injection de carburant selon la revendication 8,
**caractérisée en ce que**
le bourrelet (48) est prévu dans une région cylindrique (35) de la pièce de transition (25, 27).

10. Soupape d'injection de carburant selon l'une quelconque des revendications 1 à 9,
**caractérisée en ce que**
la pièce de transition (25, 27) est réalisée sous forme de tête d'actionneur (25) ou sous forme de base d'actionneur (27).

11. Soupape d'injection de carburant selon l'une quelconque des revendications 1 à 10,
**caractérisée en ce que**
la pièce de transition (25) est assemblée à une extrémité (24) de l'actionneur (23) et **en ce qu'**une pièce de transition supplémentaire (27) est prévue, laquelle est assemblée à une autre extrémité (26) de l'actionneur (23).

12. Soupape d'injection de carburant selon l'une quelconque des revendications 1, 3, 4, 5, 6 ou 8, **caractérisée en ce que**
le tuyau d'extension (30) peut être étendu dans au moins une région (40) de l'actionneur (23) dans une direction axiale (20), afin de permettre une extension de l'actionneur (23) dans la direction axiale (20) en vue de l'actionnement du corps de fermeture de soupape (17).
